# EUROPEAN PATENT APPLICATION

(11) **EP 2 843 009 A1**
(43) Date of publication of application: **04.03.2015**
(21) Application number: 14171831.2
(22) Date of filing: 10.06.2014
(51) Int. Cl.: C09D 5/00, G02B 1/11, H01L 31/0216, H01L 31/048, H02S 40/20, C09D 183/06, G01J 3/42

(54) **Anti-reflective coating film, solar cell including the anti-reflective coating film, and method of predicting strength of the anti-reflective coating film for the solar cell**

(30) Priority: 19.07.2013 KR 20130085697
(71) Applicant: Samsung SDI Co., Ltd., Yongin-si, Gyeonggi-do (KR)
(72) Inventor: Park, Soo-Youn, Gyeonggi-do (KR); Eom, Sang-Hyun, Gyeonggi-do (KR); Park, Do-Young, Gyeonggi-do (KR); Park, Hye-Jin, Gyeonggi-do (KR); Kim, Sung-Su, Gyeonggi-do (KR); Lee, Chun-Gyoo, Gyeonggi-do (KR); Park, Jong-Hwan, Gyeonggi-do (KR); Lee, Ji-Won, Gyeonggi-do (KR)
(74) Representative: Mounteney, Simon James

(57) **Abstract**

An anti-reflective coating film is formed from a coating solution composition that includes a silane-based precursor. When measured via Fourier Transform Infrared (FT-IR) Spectroscopy using a wavelength of 1064 nm, the coating solution composition exhibits a peak intensity ratio I_{B}/I_{A} and a peak intensity ratio I_{C}/I_{A} of equal to or greater than 0.47, respectively. The peak intensity I_{B} is in a range of about 930 cm⁻¹ to about 960 cm⁻¹, the peak intensity I_{A} is in a range of about 1110 cm⁻¹ to about 1130 cm⁻¹, and the peak intensity I_{C} is in a range of about 1020 cm⁻¹ to about 1050 cm⁻¹. A solar cell including the anti-reflective coating film, and a method of predicting the strength of the anti-reflective coating film for the solar cell have been disclosed.

## Description

### BACKGROUND

### 1. Field

The present invention relates to an anti-reflective coating film, a solar cell including the anti-reflective coating film, and a method of predicting the strength of the anti-reflective coating film for the solar cell.

### 2. Description of the Related Art

Recently, as conventional energy sources such as petroleum and coal are expected to deplete, there has been a growing interest in alternative energy sources. Among them, solar cells have been spotlighted for use as next generation devices that directly convert solar energy into electric energy by using semiconductor materials.

A solar cell has a basic structure of a diode consisting of PN junctions. Solar cells are classified into crystalline (monocrystalline, polycrystalline) substrate solar cells and thin film (amorphous, polycrystalline) solar cells according to the material used for an optical absorber layer.

In a solar cell, the solar cell active material such as silicon, gallium-arsenic, a copper-indium-selenide (CIS)-based compound, a copper-indium-gallium-selenide (CIGS)-based compound, or a CdTe compound is generally protected with an upper transparent protection material and a lower substrate protection material. A solar cell module is manufactured by fixing the solar cell active material with the protection materials.

In the solar cell module, the upper transparent protection material may be glass, i.e., a cover glass. However, glass may decrease the generation efficiency of the solar cell because it reflects sunlight. Accordingly, attempts have been made to apply an anti-reflective coating film to a solar cell module.

The anti-reflective coating film is required to have low refractivity and also a certain level of strength in order to maintain the performance of the solar cell module at a level of about ±5% for a period of about 5 - 20 years in order to minimize (or reduce) loss in the anti-reflective coating film due to external conditions. However, it is difficult to measure the strength required for a solar cell module prior to the formation of the anti-reflective coating film (i.e., in the state of a composition).

Information disclosed in this Background section was already known to the inventors of the present invention before achieving the present invention, or is technical information acquired in the process of achieving the present invention. Therefore, it may contain information that does not form the prior art that is already known in this country to a person of ordinary skill in the art.

### SUMMARY

According to an embodiment of the present disclosure, an anti-reflective coating film that is formed from a coating solution composition including a silane-based precursor exhibits a peak intensity ratio I_{B}/I_{A}, which is the ratio of a peak intensity representing a Si-OH bond over a peak intensity representing a Si-O-Si bond; and a peak intensity ratio I_{C}/I_{A}, which is the ratio of a peak intensity representing a Si-O-R (wherein R is a C₁-C₅ alkyl) over a peak intensity representing a Si-O-Si bond, both measured via Fourier Transform Infrared (FT-IR) Spectroscopy using a wavelength of 1064 nm, of equal to or greater than 0.47, respectively.

An aspect of the present disclosure is directed toward a solar cell including the anti-reflective coating film.

According to a further embodiment of the present disclosure, a method of predicting a strength of an anti-reflective coating film for a solar cell includes: measuring a coating solution composition including a silane-based precursor via FT-IR Spectroscopy using a wavelength of 1064 nm for the peak intensity ratio I_{B}/I_{A}, which is the ratio of a peak intensity representing a Si-OH bond over a peak intensity representing a Si-O-Si bond; and the peak intensity ratio I_{C}/I_{A}, which is the ratio of a peak intensity representing a Si-O-R (wherein R is a C₁-C₅ alkyl) over the peak intensity representing the Si-O-Si bond, respectively; and predicting whether the anti-reflective coating film has a strength equal to or greater than a pencil hardness 4H.

According to one embodiment of the present invention, an anti-reflective coating film is formed from a coating solution composition including a silane-based precursor, wherein the coating solution composition exhibits a peak intensity I_{B} representing a Si-OH bond in a range of about 930 cm⁻¹ to about 960 cm⁻¹; a peak intensity I_{A} representing a Si-O-Si bond in a range of about 1110 cm⁻¹ to about 1130 cm⁻¹; and a peak intensity I_{C} representing a Si-O-R (wherein R is a C₁-C₅ alkyl) in a range of about 1020 cm⁻¹ to about 1050 cm⁻¹. A peak intensity ratio I_{B}/I_{A} and a peak intensity ratio I_{C}/I_{A}, both measured via FT-IR Spectroscopy using a wavelength of 1064 nm, are equal to or greater than 0.47, respectively.

According to another embodiment, a solar cell includes: a substrate; a photoelectric conversion layer including an optical absorber layer on the substrate; a cover glass on the photoelectric conversion layer; and an anti-reflective coating film on the cover glass.

According to a further embodiment, a method of predicting the strength of an anti-reflective coating film for a solar cell includes measuring a coating solution composition including a silane-based precursor via Fourier Transform Infrared (FT-IR) Spectroscopy using a wavelength of 1064 nm for a peak intensity ratio I_{B}/I_{A} and a peak intensity ratio I_{C}/I_{A} respectively, wherein the peak intensity I_{B} represents a Si-OH bond in a range of about 930 cm⁻¹ to about 960 cm⁻¹, the peak intensity I_{A} represents a Si-O-Si bond in a range of about 1110 cm⁻¹ to about 1130 cm⁻¹, and the peak intensity I_{C} represents a Si-O-R (wherein R is a C₁-C₅ alkyl) in a range of about 1020 cm⁻¹ to about 1050 cm⁻¹, respectively; and predicting whether the anti-reflective coating film has a strength equal to or greater than a pencil hardness 4H .

According to another embodiment, an anti-reflective coating film formed from a coating solution composition including a silane-based precursor, wherein the peak intensity ratio I_{B}/I_{A}, which is the ratio of a peak intensity representing a Si-OH bond in a range of about 930 cm⁻¹ to about 960 cm⁻¹ over a peak intensity representing a Si-O-Si bond in a range of about 1110 cm⁻¹ to about 1130 cm⁻¹; and the peak intensity ratio I_{C}/I_{A}, which is the ratio of a peak intensity representing a Si-O-R (wherein R is a C₁-C₅ alkyl) in a range of about 1020 cm⁻¹ to about 1050 cm⁻¹ over the peak intensity representing the Si-O-Si bond in a range of about 1110 cm⁻¹ to about 1130 cm⁻¹, both measured via Fourier Transform Infrared (FT-IR) Spectroscopy using a wavelength of 1064 nm, are equal to or greater than 0.47, respectively, may have a strength greater than a pencil hardness 4H.

At least some of the above and other features of the invention are set out in the claims.

### BRIEF DESCRIPTION OF THE DRAWINGS

These and/or other aspects will become apparent and more readily appreciated from the following description of the embodiments, taken in conjunction with the accompanying drawings in which:
FIG. 1 shows a spectrum of a coating composition prepared according to Preparation Example 1 via Fourier Transform Infrared (FT-IR) Spectroscopy;
FIG. 2 shows a spectrum of a coating composition prepared according to Preparation Example 2 via FT-IR Spectroscopy;
FIG. 3 shows a spectrum of a coating composition prepared according to Preparation Example 3 via FT-IR Spectroscopy;
FIG. 4 shows a spectrum of a coating composition prepared according to Comparative Preparation Example 1 via FT-IR Spectroscopy;
FIG. 5 shows a spectrum of a coating composition prepared according to Comparative Preparation Example 2 via FT-IR Spectroscopy;
FIG. 6 shows a spectrum of a coating composition prepared according to Comparative Preparation Example 3 via FT-IR Spectroscopy;
FIG. 7 shows a diagram illustrating a thin film solar cell according to an example embodiment of the present invention; and
FIG. 8 shows an enlarged diagram of an enclosed photoelectric conversion layer 20 in FIG. 7.

### DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description.

Hereinafter, an anti-reflective coating film according to an embodiment of the present description, a solar cell including the anti-reflective coating film, and a method of predicting the strength of the anti-reflective coating film for the solar cell will be described in more detail. It should be understood that the example embodiments described therein should be considered in a descriptive sense only and not for purposes of limitation. The descriptions of features or aspects within each embodiment should typically be considered as available for other similar features or aspects in other embodiments.

According to one embodiment of the present invention, an anti-reflective coating film is formed from a coating solution composition including a silane-based precursor, wherein the peak intensity ratio I_{B}/I_{A}, which is the ratio of a peak intensity representing a Si-OH bond in a range of about 930 cm⁻¹ to about 960 cm⁻¹ over a peak intensity representing a Si-O-Si bond in a range of about 1110 cm⁻¹ to about 1130 cm⁻¹; and the peak intensity ratio I_{C}/I_{A}, which is the ratio of a peak intensity representing a Si-O-R (wherein R is a C₁-C₅ alkyl) in a range of about 1020 cm⁻¹ to about 1050 cm⁻¹ over a peak intensity representing a Si-O-Si bond in a range of about 1110 cm⁻¹ to about 1130 cm⁻¹, both measured via FT-IR Spectroscopy using a wavelength of 1064 nm, are both equal to or greater than 0.47, respectively.

An anti-reflective coating film generally includes SiOₓ as a major component. The anti-reflective coating film requires a refractive index that is equal to or below 1.40, and a strength equal to or greater than a pencil hardness 4H. The anti-reflective coating film of the present invention manufactured using a coating composition including the silane-based precursor can have a strength equal to or greater than a pencil hardness 4H.

The silane-based precursor may include from about 30 to about 100 parts by weight of methyltrimethoxysilane based on 100 parts by weight of the silane-based precursor. For example, the silane-based precursor may include from about 45 to 100 parts by weight of methyltrimethoxysilane based on 100 parts by weight of the silane-based precursor. In one embodiment, when methyltrimethoxysilane is included in the above range, an anti-reflective coating film with a pencil hardness that is greater than 4H can be obtained by curing the coating composition.

The silane-based precursor may further include at least one material selected from tetraethoxysilane (TEOS) or 3-glycidoxypropyltrimethoxysilane (3-GPTMS).

The TEOS may be included from about 10 to about 60 parts by weight based on 100 parts by weight of the silane-based precursor. For example, tetraethoxysilane may be included from about 10 to 50 parts by weight based on 100 parts by weight of the silane-based precursor.

The 3-GPTMS may be included from about 5 to about 70 parts by weight based on 100 parts by weight of the silane-based precursor. In one embodiment, when tetraethoxysilane and/or 3-glycidoxypropyltrimethoxysilane (3-GPTMS) are (is) further included in the above range as a silane-based precursor, an anti-reflective coating film with a pencil hardness that is greater than 4H can be easily obtained by curing of the coating composition.

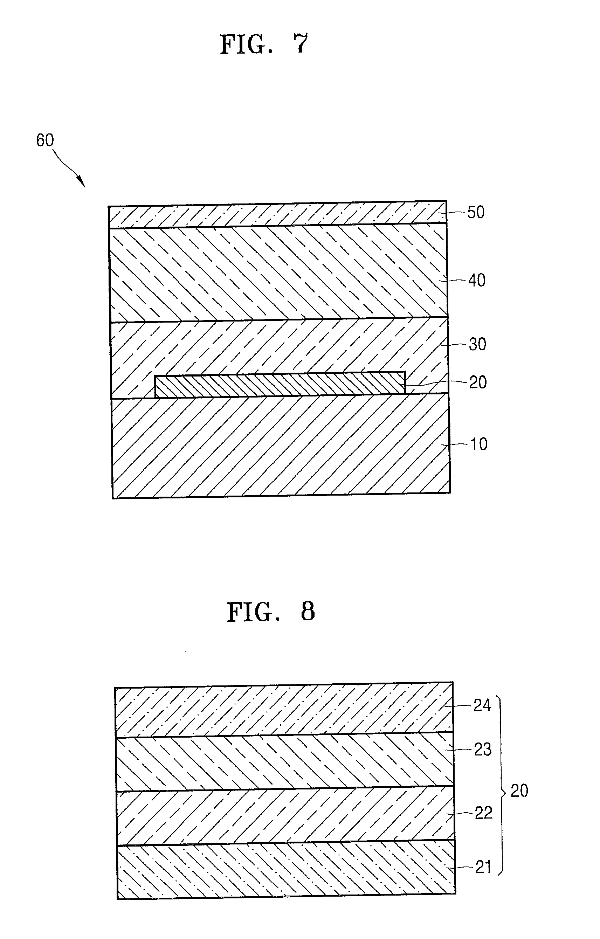

FIG. 7 shows a diagram illustrating a thin film solar cell 60 according to an example embodiment of the present invention. FIG. 8 shows an enlarged diagram of an enclosed photoelectric conversion layer 20 in FIG. 7.

In the figures, each of the components may be exaggerated, abbreviated or schematically shown for the purpose of convenience and clarifying the specification of the present invention, and the size of each component may not entirely reflect the actual size. Besides, it will be understood that when an element or layer is referred to as being "on," or "connected to" another element or layer, it can be directly on or connected to the other element or layer or intervening elements or layers may be present. When an element is referred to as being "directly on" or "directly connected to" another element or layer, there may be no intervening elements or layers present. As used herein, the term "and/or" includes any and all combinations of one or more of the associated listed items. In addition, spatially relative terms, such as "below," "beneath," "lower," "above," "upper," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. Further, the use of "may" when describing embodiments of the present invention refers to "one or more embodiments of the present invention."

Referring to FIG. 7, the thin film solar cell 60 may include a substrate 10, a photoelectric conversion layer 20 formed on the substrate 10; a cover glass 40 formed on the photoelectric conversion layer 20; and an anti-reflective coating film 50 formed on the cover glass 40. An encapsulant layer 30 formed between the photoelectric conversion layer 20 and the cover glass 40 may be further included.

First, the substrate 10 may be formed using glass or a polymer with excellent light transmittance. For example, the glass may be soda-lime glass or high-strain point soda glass, and the polymer may include polyimide, though they are not limited thereto. In addition, the glass substrate may be formed using a reinforced glass with low iron content to increase the transmittance rate of sunlight as well as to protect the internal elements of the substrate from external shock, etc. In particular, soda-lime glass with low iron content is desired because Na ions can be eluted out of the soda-lime glass during a high temperature process at 500°C or above, thereby further improving the efficiency of an optical absorber layer 22 (see FIG. 8).

Referring to FIG. 8, the photoelectric conversion layer 20 may include a backside electrode layer 21; the optical absorber layer 22 formed on the backside electrode layer 21; a buffer layer 23 formed on the optical absorber layer 22; and a transparent electrode layer 24 formed on the buffer layer 23.

The backside electrode layer 21 may be formed using a metal material having excellent conductivity and light reflectivity, such as molybdenum (Mo), aluminum (Al), or copper (Cu), to collect charges formed by a photoelectric effect, and reflect the light transmitted through the optical absorber layer 22 so that it can be reabsorbed. In particular, the backside electrode layer 21 may include Mo considering its high conductivity, ability to form ohmic contact with the optical absorber layer 22, and stability at a high temperature in a selenium (Se) atmosphere.

The backside electrode layer 21 may be formed by coating a conductive paste on the substrate 10, followed by a heat treatment, or other available plating methods. For example, the backside electrode layer 21 may be formed by sputtering using a Mo target.

The backside electrode layer 21 may have a thickness of about 200 nm to about 500 nm. The backside electrode layer 21 may be divided into a plurality of regions by one or more first separation grooves. The one or more first separation grooves may be grooves formed in parallel with a direction of the substrate 10.

The first separation grooves may be formed by first forming the backside electrode layer 21 on the substrate 10 and then dividing the backside electrode layer 21 by a first patterning into a plurality of regions. The first patterning may be, for example, performed by laser scribing. During the laser scribing, part of the backside electrode layer 21 is evaporated by laser irradiation toward the substrate 10 from a lower part of the substrate 10, and the one or more first separation grooves, which divide the backside electrode layer 21 into a plurality of regions at regular intervals, are formed by laser scribing.

The backside electrode layer 21 may be doped with alkali ions, such as Na. For example, during the growth of the optical absorber layer 22, the alkali ions doped on the backside electrode layer 21 are introduced into the optical absorber layer 22, thereby producing a positive structural effect on the optical absorber layer 22 and improving the conductivity thereof. As such, the open voltage (V_{OC}) of a solar cell 60 can be increased to thereby improve the efficiency of the solar cell 60.

Furthermore, the backside electrode layer 21 may be formed as multiple layers to secure resistance characteristics of the backside electrode layer 21 as well as adherence to the substrate 10.

The optical absorber layer 22 may be a P-type conductive layer by including Cu(In,Ga)(Se,S)₂ compounds substituted with S or substituted with Cu(In, Ga)Se₂ compound without S, and may absorb sunlight. The optical absorber layer 22 may be formed to have a thickness of about 0.7 µm to about 2 µm, and also formed within the first separation grooves that divide the backside electrode layer 21.

The optical absorber layer 22 may be formed by a co-evaporation method in which Cu, In, Ga, Se, etc. are added into a small electric furnace installed inside a vacuum chamber and heated therein; or a sputtering/selenization method in which a CIG-based metal precursor film is formed on the backside electrode layer 21 by using a Cu target, an In target, and a Ga target, and then heat treating in an H₂Se gas atmosphere to allow the CIG-based metal precursor film to react with Se to thus form the optical absorber layer 22. Furthermore, the optical absorber layer 22 may be formed by an electro-deposition method, a metal-organic chemical vapor deposition method (MOCVD), etc.

The buffer layer 23 reduces both a band gap between the optical absorber layer 22 of a P-type and the transparent electrode layer 24 of an N-type, and a recombination between electrons and holes at the interface with the transparent electrode layer 24. The buffer layer 23 may be formed by chemical bath deposition (CBD) as described above.

The optical absorber layer 22 and the buffer layer 23 may be divided into a plurality of regions by one or more second separation grooves. The second separation grooves may be formed in parallel with the first separation grooves at a different location from the first separation grooves, and the upper side of the backside electrode layer 21 is exposed to the outside by the second separation grooves.

After forming the optical absorber layer 22 and the buffer layer 23, the second separation grooves are formed by performing a second patterning. The second patterning may be performed, for example, by mechanical scribing, wherein a sharp tool such as a needle is moved in parallel with the first separation grooves at a location separate from the first separation grooves to thereby form the second separation grooves. However, the present invention is not limited thereto, and a laser may also be used.

The second patterning divides the optical absorber layer 22 into a plurality of regions, and the second separation grooves formed by the second patterning extend to the upper side of the backside electrode layer 21 to thereby expose the backside electrode layer 21 to the outside.

The transparent electrode layer 24 forms a P-N junction with the optical absorber layer 22. Further, the transparent electrode layer 24 includes transparent conductive materials, such as ZnO:B, AZO, ITO, or IZO, and traps charges formed by a photoelectric effect. The transparent electrode layer 24 may be formed by metal-organic chemical vapor deposition (MOCVD), low pressure chemical vapor deposition (LPCVD), or sputtering.

Further, although not shown in the figures, the upper side of the transparent electrode layer 24 may be subjected to texturing in order to reduce the reflection of sunlight incident thereon and increase the light absorption by the optical absorber layer 22.

The transparent electrode layer 24 may be also formed within the second separation grooves, and by contacting the backside electrode layer 21 exposed by the second separation grooves, the transparent electrode layer 24 can be electrically connected to the optical absorber layer 22, which is divided into a plurality of regions by the second separation grooves.

The transparent electrode layer 24 may be divided into a plurality of regions by one or more third separation grooves formed in a location different from those of the first separation grooves and the second separation grooves. The third separation groove may be formed in parallel with the first separation grooves and the second separation grooves and may extend to the upper side of the backside electrode layer 21. The third separation grooves may be filled with an insulation material, such as air.

The third separation grooves may be formed by performing a third patterning. The third patterning may be performed by mechanical scribing, and the third separation grooves formed by the third patterning may extend to the upper side of the backside electrode layer 21, thereby forming a plurality of photoelectric conversion parts. In addition, the third separation grooves may be filled with air, thus forming an insulation layer.

The encapsulant layer 30 may be formed by using one material selected from ethylene vinyl acetate (EVA) copolymer resin, polyvinyl butyral, ethylene vinyl acetate moiety oxide, silicon resin, ester-based resin, or olefin-based resin.

Although not shown in the figures, the upper side of the transparent electrode layer 24 may have a textured surface. Texturing refers to forming a rugged pattern on the upper side by a physical or chemical method. When the surface of the transparent electrode layer 24 is rough due to texturing, the reflection rate of incident light thereon decreases, thereby increasing the amount of trapped light. Accordingly, the texturing reduces optical loss.

According to another embodiment of the present invention, a method of predicting the strength of an anti-reflective coating film for a solar cell includes measuring a coating solution composition including a silane-based precursor via FT-IR Spectroscopy using a wavelength of 1064 nm for the peak intensity ratio I_{B}/I_{A}, which is the ratio of a peak intensity I_{B} representing a Si-OH bond in a range of about 930 cm⁻¹ to about 960 cm⁻¹ over a peak intensity I_{A} representing a Si-O-Si bond in a range of about 1110 cm⁻¹ to about 1130 cm⁻¹; and the peak intensity ratio I_{C}/I_{A}, which is the ratio of a peak intensity I_{C} representing a Si-O-R (wherein R is a C₁-C₅ alkyl) in a range of about 1020 cm⁻¹ to about 1050 cm⁻¹ over the peak intensity I_{A} representing the Si-O-Si bond in a range of about 1110 cm⁻¹ to about 1130 cm⁻¹, respectively; and predicting whether the anti-reflective coating film has a strength equal to or greater than a pencil hardness 4H.

In order to obtain a strength that is equal to or greater than a pencil hardness 4H required for an anti-reflective coating film, the composition of an anti-reflective coating film may be modified or sintered at a high temperature from about 100 to about 700°C.

However, the modification or sintering at a high temperature does not guarantee that the anti-reflective coating film for a solar cell formed from the coating composition will have a strength equal to or greater than a pencil hardness 4H.

The method according to the present embodiment enables one to predict, at a stage before forming a film, whether the strength of an anti-reflective coating film for a cover glass of a solar cell to be formed from the coating composition including a silane-based precursor will be equal to or greater than a pencil hardness 4H, by respectively measuring the peak intensity ratio I_{B}/I_{A}, which is the ratio of a peak intensity I_{B} representing a Si-OH bond in a range of about 930 cm⁻¹ to about 960 cm⁻¹ over a peak intensity I_{A} representing a Si-O-Si bond in a range of about 1110 cm⁻¹ to about 1130 cm⁻¹; and the peak intensity ratio I_{C}/I_{A}, which is the ratio of a peak intensity I_{C} representing a Si-O-R (wherein R is a C₁-C₅ alkyl) in a range of about 1020 cm⁻¹ to about 1050 cm⁻¹ over the peak intensity I_{A} representing the Si-O-Si bond in a range of about 1110 cm⁻¹ to about 1130 cm⁻¹, via FT-IR Spectroscopy using a wavelength of 1064 nm.

For example, the method enables one to predict the formation of an anti-reflective coating film with a strength equal to or greater than a pencil hardness 4H, when the the peak intensity ratio I_{B}/I_{A}, which is the ratio of a peak intensity I_{B} representing a Si-OH bond in a range of about 930 cm⁻¹ to about 960 cm⁻¹ over a peak intensity I_{A} representing a Si-O-Si bond in a range of about 1110 cm⁻¹ to about 1130 cm⁻¹; and the peak intensity ratio I_{C}/I_{A}, which is the ratio of a peak intensity I_{C} representing a Si-O-R (wherein R is a C₁-C₅ alkyl) in a range of about 1020 cm⁻¹ to about 1050 cm⁻¹ over the peak intensity I_{A} representing the Si-O-Si bond in a range of about 1110 cm⁻¹ to about 1130 cm⁻¹, are equal to or greater than 0.47, respectively.

For example, the method enables one to predict the formation of an anti-reflective coating film with a strength equal to or greater than a pencil hardness 4H, when the peak intensity ratio I_{B}/I_{A}, which is the ratio of a peak intensity I_{B} representing a Si-OH bond in a range of about 930 cm⁻¹ to about 960 cm⁻¹ over a peak intensity I_{A} representing a Si-O-Si bond in a range of about 1110 cm⁻¹ to about 1130 cm⁻¹; and the peak intensity ratio I_{C}/I_{A}, which is the ratio of a peak intensity I_{C} representing a Si-O-R (wherein R is a C₁-C₅ alkyl) in a range of about 1020 cm⁻¹ to about 1050 cm⁻¹ over the peak intensity I_{A} representing the Si-O-Si bond in a range of about 1110 cm⁻¹ to about 1130 cm⁻¹, are equal to or greater than 0.5, respectively.

The silane-based precursor may include from about 30 to about 100 parts by weight of methyltrimethoxysilane based on 100 parts by weight of the silane-based precursor. For example, the silane-based precursor may include from about 45 to about 100 parts by weight of methyltrimethoxysilane based on 100 parts by weight of the silane-based precursor.

The silane-based precursor may further include at least one material selected from TEOS or 3-GPTMS.

The TEOS may be included from about 10 to about 60 parts by weight based on 100 parts by weight of the silane-based precursor. For example, tetraethoxysilane may be included from about 10 to 50 based on 100 parts by weight of silane-based precursor.

The 3-GPTMS may be included from about 5 to about 70 parts by weight based on 100 parts by weight of the silane-based precursor. In one embodiment, when tetraethoxysilane and/or 3-GPTMS are(is) further included in the above range as a silane-based precursor, an anti-reflective coating film with a pencil hardness that is greater than 4H can be easily obtained by easy curing of the coating composition.

Hereinafter, the present invention is further illustrated by the following examples and comparative examples. However, it shall be understood that these examples are only used to specifically set forth the present disclosure, and they are not limitative in any form.

### Examples

### Manufacture of a coating composition for a solar cell

### Preparation Example 1

140 g of Methyltrimethoxysilane (Aldrich) and 140 g of tetraethoxysilane (Aldrich) at a weight ratio of 50:50 based on 100 parts by weight of a silane precursor and 350 g of ethanol were mixed at room temperature, and stirred for 10 minutes to obtain a mixture (Mixture A). 300 g of distilled water and 5 g of an aqueous nitric acid were mixed at room temperature, and stirred for 10 minutes to obtain a mixture (Mixture B). The Mixture B was added to the Mixture A, a sol-gel reaction was performed at 50°C for 4 hours, and 1000 g of alcohol was added to finally obtain a coating composition.

### Preparation Example 2

125 g of Methyltrimethoxysilane (Aldrich), 125 g of tetraethoxysilane (Aldrich), and 40 g of 3-GPTMS (Aldrich) at a weight ratio of 43:43:14 based on 100 parts by weight of a silane precursor and 350 g of ethanol were mixed at room temperature, and stirred for 10 minutes to obtain a mixture (Mixture C). 300 g of distilled water and 2.5 g of an aqueous nitric acid were mixed at room temperature, and stirred for 10 minutes to obtain a mixture (Mixture J). The Mixture J was added to the Mixture C, a sol-gel reaction was performed at 50°C for 4 hours, and 1000 g of alcohol was added to finally obtain a coating composition.

### Preparation Example 3

105 g of Methyltrimethoxysilane (Aldrich), 105 g of tetraethoxysilane (Aldrich) and 110 g of 3-GPTMS (Aldrich) at a weight ratio of 33:33:34 based on 100 parts by weight of a silane precursor and 350 g of ethanol were mixed at room temperature, and stirred for 10 minutes to obtain a mixture (Mixture D). 300 g of distilled water and 2.5 g of an aqueous nitric acid were mixed at room temperature, and stirred for 10 minutes to obtain a mixture (Mixture J). The Mixture J was added to the Mixture D, a sol-gel reaction was performed at 50°C for 4 hours, and 1000 g of alcohol was added to finally obtain a coating composition.

### Comparative Preparation Example 1

350 g of tetraethoxysilane (Aldrich), i.e. 100 parts by weight of tetraethoxysilane (Aldrich) based on 100 parts by weight of a silane precursor and 350 g of ethanol were mixed at room temperature, and stirred for 10 minutes to obtain a mixture (Mixture E). 300 g of distilled water and 5 g of an aqueous nitric acid were mixed at room temperature, and stirred for 10 minutes to obtain a mixture (Mixture B). The Mixture B was added to the Mixture E, a sol-gel reaction was performed at 50°C for 4 hours, and 1000 g of alcohol was added to finally obtain a coating composition.

### Comparative Preparation Example 2

55 g of Methyltrimethoxysilane (Aldrich) and 265 g of tetraethoxysilane (Aldrich) at a weight ratio of 20:80 based on 100 parts by weight of a silane precursor and 350 g of ethanol were mixed at room temperature, and stirred for 10 minutes to obtain a mixture (Mixture F). 300 g of distilled water and 2.5 g of an aqueous nitric acid were mixed at room temperature, and stirred for 10 minutes to obtain a mixture (Mixture J). The Mixture J was added to the Mixture F, a sol-gel reaction was performed at 50°C for 4 hours, and 1000 g of alcohol was added to finally obtain a coating composition.

### Comparative Preparation Example 3

252 g of Silica nanoparticles (Nalco), 14 g of tetraethoxysilane (Aldrich), and 14 g of methyltrimethoxysilane (Aldrich) at a weight ratio of 90:5:5 based on 100 parts by weight of a silane precursor and 350 g of ethanol were mixed at room temperature, and stirred for 10 minutes to obtain a mixture (Mixture G). 300 g of distilled water and 5 g of an aqueous nitric acid were mixed at room temperature, and stirred for 10 minutes to obtain a mixture (Mixture B). The Mixture B was added to the Mixture G, a sol-gel reaction was performed at 50°C for 4 hours, and 1000 g of alcohol was added to finally obtain a coating composition.

Manufacture of an anti-reflective coating film for a solar cell

### Example 1

The coating composition prepared in Preparation Example 1 was coated on a glass with a thickness of 3.2 mm, cured while being sintered and dried at 300°C for 30 minutes, and an anti-reflective coating film for a solar cell was formed.

### Example 2

An anti-reflective coating film for a solar cell was obtained in the same manner as in Example 1 except that the coating composition prepared in Preparation Example 2 was used instead of Preparation Example 1.

### Example 3

An anti-reflective coating film for a solar cell was obtained in the same manner as in Example 1 except that the coating composition prepared in Preparation Example 3 was used instead of Preparation Example 1.

### Comparative Example 1

An anti-reflective coating film for a solar cell was obtained in the same manner as in Example 1 except that the coating composition prepared in Comparative Preparation Example 1 was used instead of Preparation Example 1.

### Comparative Example 2

An anti-reflective coating film for a solar cell was obtained in the same manner as in Example 1 except that the coating composition prepared in Comparative Preparation Example 2 was used instead of Preparation Example 1.

### Comparative Example 3

An anti-reflective coating film for a solar cell was obtained in the same manner as in Example 1 except that the coating composition prepared in Comparative Preparation Example 3 was used instead of Preparation Example 1.

### Manufacture of a solar cell

### Example 4

A soda lime glass substrate with a thickness of about 1 mm and sheathed with a Mo backside electrode layer was prepared. A CuGa target and an In target were respectively sputtered on the soda lime glass substrate sheathed with an Mo backside electrode layer, and the soda lime glass substrate was then heat-treated in an H₂Se and H₂S atmosphere at 400°C for 20 minutes and at 550°C for 60 minutes, respectively, thereby forming an optical absorber layer having a composition of CuIn_{0.7}Ga_{0.3}SSe₂.

The soda lime glass substrate on which an optical absorber layer was formed, was immersed into a solution mixed with 2 M ammonia water (NH₄OH), 0.03 M zinc sulfide hydrate (ZnSO₄·7H₂O), and 0.3 M thiourea (CS(NH₂)₂) for 10 minutes. The soda lime glass substrate was washed with distilled water, dried under N₂ gas for 5 minutes, and a ZnS buffer layer was formed with a thickness of 0.5 nm on the optical absorber layer.

Then, a ZnO transparent electrode layer was formed on the ZnS buffer layer by a metal-organic chemical vapor deposition (MOCVD) method. An encapsulant layer was formed on the ZnO transparent electrode layer with ethylene vinyl acetate (EVA) copolymer resin, and a cover glass was formed on the encapsulant layer. Finally, an anti-reflective coating film as prepared in Example 1 was formed on the cover glass and thus a solar cell was completely manufactured.

### Example 5

A solar cell was manufactured in the same manner as in Example 4 except that an anti-reflective coating film as prepared in Example 2 instead of Example 1 was formed on the cover glass.

### Example 6

A solar cell was manufactured in the same manner as in Example 4 except that an anti-reflective coating film as prepared in Example 3 instead of Example 1 was formed on the cover glass.

### Comparative Example 4

A solar cell was manufactured in the same manner as in Example 4 except that an anti-reflective coating film as prepared in Comparative Example 1 instead of Example 1 was formed on the cover glass.

### Comparative Example 5

A solar cell was manufactured in the same manner as in Example 4 except that an anti-reflective coating film as prepared in Comparative Example 2 instead of Example 1 was formed on the cover glass.

### Comparative Example 6

A solar cell was manufactured in the same manner as in Example 4 except that an anti-reflective coating film as prepared in Comparative Example 3 instead of Example 1 was formed on the cover glass.

### Experimental Example 1: Measurement of Peak Intensity via FT-IR Spectroscopy

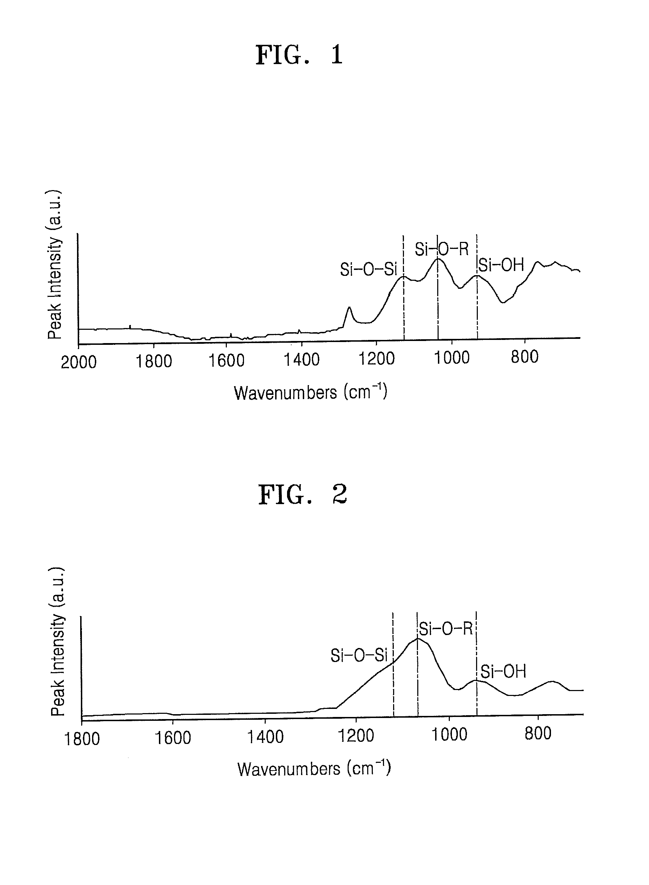

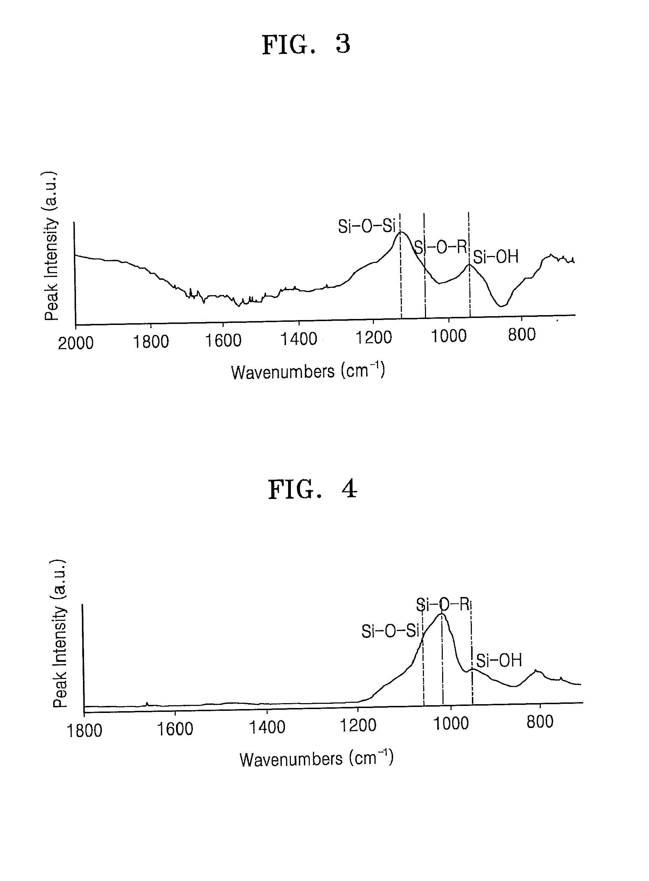

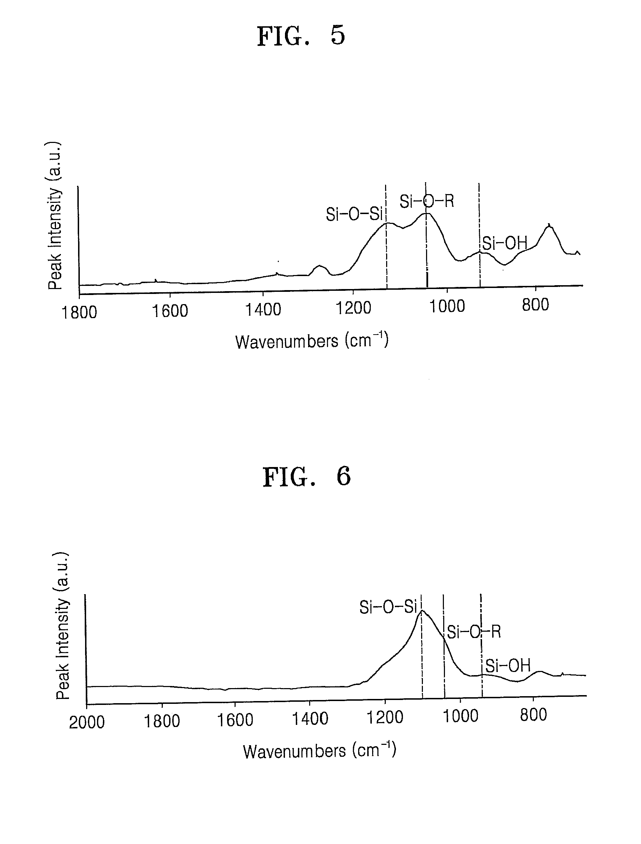

Coating compositions prepared in Preparation Examples 1-3 and Comparative Preparation Examples 1-3 were respectively measured, via FT-IR (Nicolet 670 FT-IR spectrometer, Thermo Fisher Scientific Inc.) using a wavelength of 1064 nm, for the peak intensity and calculation of the peak intensity ratio I_{B}/I_{A}, which is the ratio of a peak intensity I_{B} representing a Si-OH bond in a range of about 930 cm⁻¹ to about 960 cm⁻¹ over a peak intensity I_{A} representing a Si-O-Si bond in a range of about 1110 cm⁻¹ to about 1130 cm⁻¹; and the peak intensity ratio I_{C}/I_{A}, which is the ratio of a peak intensity I_{C} representing a Si-O-R (wherein R is a C₁-C₅ alkyl) in a range of about 1020 cm⁻¹ to about 1050 cm⁻¹ over the peak intensity I_{A} representing the Si-O-Si bond in a range of about 1110 cm⁻¹ to about 1130 cm⁻¹. The results are shown in FIGS. 1-6, and Table 1 below.

**Table 1**

| Category | I_{B}/I_{A} | I_{C}/I_{A} |
|---|---|---|
| Preparation Example 1 | 1.00 | 1.29 |
| Preparation Example 2 | 0.63 | 1.46 |
| Preparation Example 3 | 0.74 | 0.63 |
| Comparative Preparation Example 1 | 0.43 | 1.20 |
| Comparative Preparation Example 2 | 0.46 | 1.13 |
| Comparative Preparation Example 3 | 0.26 | 0.67 |

Referring to FIGS. 1-6 and Table 1, the ratios I_{B}/I_{A} and I_{C}/I_{A} of the coating compositions prepared in Preparation Examples 1-3 were greater than 0.5. In contrast, one of the ratios I_{B}/I_{A} and I_{C}/I_{A} of the coating compositions prepared in Comparative Examples 1-3 were below 0.5.

### Experimental Example 2: Measurement of Strength of Anti-reflective coating film

The strengths of the anti-reflective coating films for a solar cell prepared in Examples 1-3 and Comparative Examples 1-3 were measured as pencil hardness according to ASTM D 3363, and the results are shown in Table 2 below.

**Table 2**

| Category | Pencil Hardness (H) |
|---|---|
| Example 1 | 4 |
| Example 2 | 4 |
| Example 3 | 4 |
| Comparative Example 1 | 2 |
| Comparative Example 2 | 2 |
| Comparative Example 3 | < 1 |

Referring to Table 2, the pencil hardnesses measured for the anti-reflective coating films for solar cells prepared in Examples 1-3 were 4H. In contrast, the pencil hardnesses measured for the anti-reflective coating films for solar cells prepared in Comparative Examples 1-3 were 2H or below 1 H.

Accordingly, it was confirmed that when both ratios I_{B}/I_{A} and I_{C}/I_{A} were greater than 0.5 as in Preparation Example 1-3, the pencil hardnesses of the anti-reflective coating films for solar cells in Examples 1-3 were 4H. In contrast, the pencil hardnesses of the anti-reflective coating films for solar cells prepared in Comparative Examples 1-3, where one of the ratios I_{B}/I_{A} and I_{C}/I_{A} of the coating compositions was below 0.5, were 2H or below 1 H.

It should be understood that the example embodiments described herein should be considered in a descriptive sense only and not for purposes of limitation. Descriptions of features or aspects within each embodiment should typically be considered as available for other similar features or aspects in other embodiments.

While one or more embodiments of the present invention have been described with reference to the figures, it will be understood by those of ordinary skill in the art that various changes in form and details may be made therein without departing from the scope of the present invention as defined by the following claims, and equivalents thereof.

## Claims

1. An anti-reflective coating film formed from a coating solution composition comprising a silane-based precursor, wherein the coating solution composition exhibits a peak intensity I_{B} representing a Si-OH bond in a range of from 930 cm⁻¹ to 960 cm⁻¹; a peak intensity I_{A} representing a Si-O-Si bond in a range of from 1110 cm⁻¹ to 1130 cm⁻¹; and a peak intensity I_{C} representing a Si-O-R (wherein R is a C₁-C₅ alkyl) in a range of from 1020 cm⁻¹ to 1050 cm⁻¹ measured via Fourier Transform Infrared (FT-IR) Spectroscopy using a wavelength of 1064 nm, wherein a peak intensity ratio I_{B}/I_{A} and a peak intensity ratio I_{C}/I_{A} are each equal to or greater than 0.47.

2. A anti-reflective coating film according to claim 1, wherein the silane-based precursor comprises from 30 to 100 parts by weight of methyltrimethoxysilane based on 100 parts by weight of the silane-based precursor.

3. A anti-reflective coating film according to claim 2, wherein the silane-based precursor further comprises at least one selected from tetraethoxysilane (TEOS) or 3-glycidoxypropyltrimethoxysilane (3-GPTMS).

4. A anti-reflective coating film according to claim 3, wherein the TEOS is from 10 to 60 parts by weight based on 100 parts by weight of the silane-based precursor.

5. A anti-reflective coating film according to claim 3, wherein the 3-GPTMS is from 5 to 70 parts by weight based on 100 parts by weight of the silane-based precursor.

6. A solar cell comprising:
a substrate,
a photoelectric conversion layer comprising an optical absorber layer on the substrate;
a cover glass on the photoelectric conversion layer; and
the anti-reflective coating film according to any preceding claim on the cover glass.

7. A solar cell according to claim 6, further comprising an encapsulant layer between the photoelectric conversion layer and the cover glass.

8. A solar cell according to claim 6, wherein the solar cell is a thin film solar cell.

9. A solar cell according to claim 6 or 7, wherein the optical absorber layer comprises a Cu(In,Ga)Se₂(CIGS-based) compound.

10. A method of predicting a strength of an anti-reflective coating film for a solar cell, the method comprising:
measuring a coating solution composition comprising a silane-based precursor via Fourier Transform Infrared (FT-IR) Spectroscopy using a wavelength of 1064 nm, for a peak intensity ratio I_{B}/I_{A} and a peak intensity ratio I_{C}/I_{A} respectively, wherein the peak intensity I_{B} represents a Si-OH bond in a range of from 930 cm⁻¹ to 960 cm⁻¹; the peak intensity I_{A} represents a Si-O-Si bond in a range of from 1110 cm⁻¹ to 1130 cm⁻¹; and the peak intensity I_{C} represents a Si-O-R (wherein R is a C₁-C₅ alkyl) in a range of 1020 cm⁻¹ to 1050 cm⁻¹, respectively; and
predicting whether the anti-reflective coating film has a strength equal to or greater than a pencil hardness 4H based on the peak intensity ratio I_{B}/I_{A} and the peak intensity ratio I_{C}/I_{A}.

11. A method according to claim 10, wherein the method predicts the strength of an anti-reflective coating film for a solar cell to be equal to or greater than a pencil hardness 4H when the peak intensity ratio I_{B}/I_{A} and the peak intensity ratio I_{C}/I_{A} are equal to or greater than 0.47, respectively.

12. A method according to claim 10 or 11, wherein the silane-based precursor comprises from about 30 to about 100 parts by weight of methyltrimethoxysilane based on 100 parts by weight of the silane-based precursor.

13. The method according to claim 10, 11 or 12, wherein the silane-based precursor further comprises at least one selected from tetraethoxysilane (TEOS) or 3-glycidoxypropyltrimethoxysilane (3-GPTMS).

14. A method according to claim 13, wherein the TEOS is from about 10 to about 60 parts by weight based on 100 parts by weight of the silane-based precursor.

15. The method according to claim 13, wherein the 3-GPTMS is from about 5 to about 70 parts by weight based on 100 parts by weight of the silane-based precursor.
